Europäisches Patentamt

(19) European Patent Office

Office européen des brevets

(11) Numéro de publication: **0 245 563**
**B1**

(12) **FASCICULE DE BREVET EUROPEEN**

(45) Date de publication du fascicule du brevet:
**14.06.89**

(51) Int. Cl.⁴: **G01F 23/28**, G01R 31/02

(21) Numéro de dépôt: **86400911.3**

(22) Date de dépôt: **24.04.86**

(54) Détecteur de niveau optique électronique à capteur double.

(43) Date de publication de la demande:
**19.11.87 Bulletin 87/47**

(45) Mention de la délivrance du brevet:
**14.06.89 Bulletin 89/24**

(84) Etats contractants désignés:
**AT BE CH DE FR GB IT LI LU NL SE**

(56) Documents cités:
**CH-A- 404 224**
**CH-A- 615 995**
**DE-A- 2 927 449**
**DE-A- 3 533 523**
**FR-A- 2 238 919**
**GB-A- 1 518 492**

**PRODUCT ENGINEERING,**
**vol. 39, no. 20, 23 septembre 1968, pages 81,82:**
**"Optical switch uses reflection to monitor the level of liquid"**
**EDN MAGAZINE;**
**vol. 26, 14 Octobre 1981, page 379, Boston, Mass., US;**
**E.J. WHITESELL: "Schmitt triggers isolate coax faults"**

(73) Titulaire: **EQUIPEMENT INDUSTRIEL NORMAND,**
**F-14540 Grentheville près Caen(FR)**

(72) Inventeur: **Coquerel, Claude Maurice, 8 Chemin des Côteaux Fleury Sur Orne, F-14123 Ifs(FR)**
Inventeur: **Van de Kamer, Johan, 1 rue Roger Poulain, F-14200 Herouville St Clair(FR)**

(74) Mandataire: **Madeuf, René Louis et al, Cabinet Madeuf 3, Avenue Bugeaud, F-75116 Paris(FR)**

## Description

La présence invention concerne un dispositif à capteur double pour la réalisation de détecteurs de niveau.

Il existe de nombreux cas où il est nécessaire de détecter l'arrivée d'un liquide à un niveau déterminé. Par exemple, dans le bloc combiné dégazeur, purgeur, bloqueur, récupérateur pour appareils de mesure volumétrique à sécurité renforcée selon la demande de brevet européen 84 401 652.7, il existe un détecteur de niveau basé sur le principe d'un flotteur muni d'une ferrite actionnant un contact à lame souple et fournissant ainsi un signal de proximité suivant le niveau de liquide.

Le présent détecteur est basé sur un principe totalement différent de type opto-électronique.

Conformément à l'invention, le détecteur comprend un prisme à réflexion totale réalisé en une matière transparente, deux capteurs émetteurs récepteurs reliés par paire, d'une part, de manière optique audit prisme et, d'autre part, de manière électrique à un dispositif logique en permettant ainsi de détecter la présence ou l'absence d'un signal reçu par au moins un des récepteurs de la paire de capteurs.

Suivant d'autres caractéristiques de l'invention, le prisme à réflexion totale est réalisé en une matière transparente et présente une forme cylindro-conique d'angle au sommet inférieur égal à 90° et dont la partie plane supérieure reçoit la paire de capteurs disposés dans l'axe médian du cône perpendiculairement l'un à l'autre. Les récepteurs de la paire de capteurs sont au niveau logique 0 lorsqu'ils reçoivent une information émise par les émetteurs et au niveau logique 1 dans le cas contraire, le dispositif logique de détection présentant la forme d'une porte NAND à fonction NON-ET.

Suivant encore une autre particularité de l'invention, les émetteurs et les récepteurs de la paire de capteurs sont chacun constitués par des cellules de type infrarouge et les sorties des deux émetteurs et des deux récepteurs présentent des liaisons communes respectivement reliées à une première entrée de comparateurs dont la seconde entrée reçoit des tensions de référence. En outre, la sortie des divers comparateurs est reliée en commun à la première entrée d'une seconde porte NAND dont la seconde entrée est reliée à la sortie de la première porte NAND, la sortie de cette seconde porte NAND constituant une sortie du dispositif.

L'invention sera mieux comprise à la lecture de la description ci-après et à l'examen des dessins annexés dans lesquels :

Les fig. 1 et 2 représentent schématiquement la partie optique d'un détecteur de type connu dans deux positions de fonctionnement ;
la fig. 3 représente schématiquement la partie optique du détecteur selon l'invention ;
la fig. 4 est un schéma de principe de l'ensemble du détecteur de niveau selon l'invention.

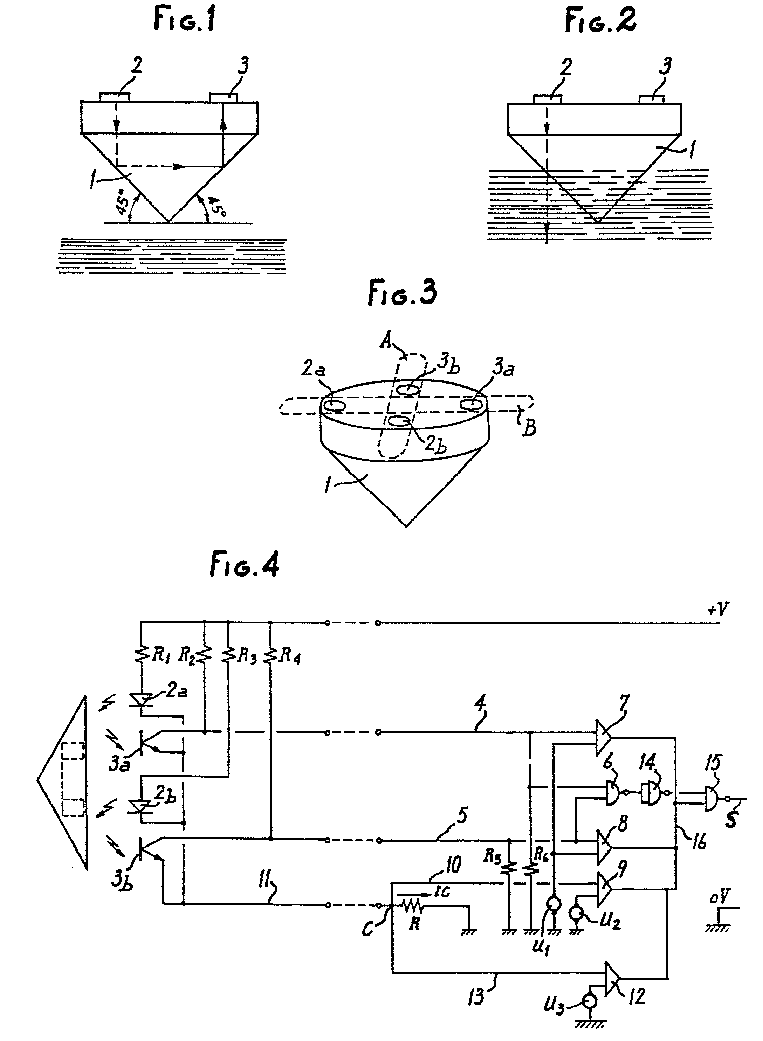

Aux fig. 1 et 2, un prisme à réflexion totale est réalisé en verre ou en une matière plastique transparente de type usuel en optique. Le prisme 1 est de forme cylindroconique à angle au sommet de 90°. La face supérieure du prisme 1 reçoit un émetteur 2 et un récepteur 3, par exemple du type cellule à infrarouge placés dans l'axe médian du cône définissant le prisme, l'ensemble formant un capteur émetteur-récepteur.

La fig. 1 montre une disposition de rayons lumineux lorsque le prisme 1 est totalement dans l'air. Le rayon lumineux émis représenté en traits interrompus est réfléchi par deux réflexion à 90°, le rayon reflété correspondant, représenté en trait continu, est alors perçu par le récepteur 3.

La fig. 2 montre la disposition des rayons lumineux lorsque le prisme 1 est en partie immergé dans le liquide 4. Dans un tel cas, le rayon lumineux émis est réfracté et passe dans le liquide 4 de sorte que le récepteur 3 ne reçoit plus de lumière.

Un tel système est connu en soi dans la technique de l'optique comme dans l'industrie et est par exemple décrit dans la revue "Product Engineering" vol. 39, No 20 du 23 septembre 1968, pages 81, 82 intitulé "Optical switch uses reflection to monitor the level of liquid". Toutefois, cette disposition n'est pas directement utilisable en métrologie.

En effet, le Service de la Métrologie auquel est assujetti, par exemple, le contrôle du bloc combiné décrit dans la demande de brevet européen 84 401 652.7 ci-dessus exige, au niveau de la détection du liquide, un fonctionnement dit à sécurité positive. Selon le Service de la Métrologie, une telle sécurité positive implique que la non-émission ou la non-réception du rayon lumineux di-dessus puisse être détectée quelle que soit l'origine du défaut (présence de liquide au niveau du détecteur, capteur émetteur-récepteur défectueux, défaut dans la partie électronique ou électrique à laquelle est relié le détecteur...).

Afin d'assurer une telle sécurité positive et, comme on le voit aux fig. 3 et 4, le détecteur selon l'invention comprend un capteur double formé d'une paire de capteurs A et B. Le capteur double est monté dans un prisme analogue au prisme 1 des fig. 1 et 2 et est relié à un circuit électronique approprié.

Deux cellules émettrices 2a et 2b et deux cellules réceptrices 3a et 3b respectivement semblables aux cellules 2 et 3 de la fig. 1, sont montées à 180° par paire A et B de capteurs émetteurs-récepteurs à 90° l'un de l'autre. Un tel montage permet d'assurer qu'il n'existe aucune interférence entre les capteurs.

A la fig. 4, des cellules émettrices 2a et 2b sont respectivement montées en parallèle entre une alimentation +V et la terre par l'intermédiaire de résistances $R_1$ et $R_3$ et d'une résistance de shunt R. De même, les cellules réceptrices 3a et 3b ont leurs entrées directement reliées à la sortie des cellules émettrices 2a et 2b et leurs sorties sont reliées entre l'alimentation +V et la masse O volt par l'intermédiaire d'un pont de résistance constitué respectivement par les résistances $R_2$, $R_6$ et $R_4$, $R_5$.

Conformément à l'invention, les niveaux logiques de sortie des deux cellules réceptrices 3a et 3b sont, de préférence, établis de telle manière qu'un niveau O correspond à une absence de liquide et un niveau 1 à la détection d'une présence de liquide, cas dans lequel les cellules réceptrices ne reçoivent plus de lumière issue des cellules émettrices.

Les sorties des cellules réceptrices $3\underline{a}$ et $3\underline{b}$ sont alors reliées par des liaisons 4 et 5 à une porte NAND 6 à fonction NON-ET. Ainsi, les deux capteurs doivent être au niveau 1 afin d'obtenir un niveau O à la sortie du circuit NAND 6 dans le cas de la détection de liquide.

De manière à assurer des fonctions complémentaires dont il sera question plus loin, on prévoit en outre des comparateurs montés entre une source de référence et les sorties des divers élements des capteurs.

Des comparateurs 7 et 8 présentent ainsi une de leurs entrées reliées par des liaisons 4 et 5 aux sorties correspondantes des cellules réceptrices $3\underline{a}$ et $3\underline{b}$, tandis que l'autre entrée des comparateurs 7 et 8 est reliée à une tension de référence $U_1$. De même un comparateur 9 est relié par une liaison 10-11 directement à la sortie des cellules émettrices $2\underline{a}$ et $2\underline{b}$ et donc à l'entrée des cellules réceptrices $3\underline{a}$ et $3\underline{b}$. Le comparateur 9 est en outre relié par son autre entrée à une tension de référence $U_2$. Un quatrième comparateur, référencé 12, est également relié par une liaison 13-11 à la sortie des cellules émettrices $2\underline{a}$ et $2\underline{b}$ et son autre entrée reçoit une tension de référence $U_3$.

La sortie de la porte NAND ci-dessus est, en outre, reliée par une porte 14 à la première entrée d'une seconde porte NAND 15 dont l'autre entrée est reliée par une liaison 16 à la sortie commune des comparateurs 7, 8, 9 et 12. La sortie $\underline{S}$ de la porte NAND 15 correspond à la sortie de l'ensemble du dispositif.

La disposition qui précède permet de détecter les divers défauts définis ci-après.

1°/ coupure d'une ou des liaisons d'alimentation.

Les liaisons d'alimentation du dispositif sont constituées par la liaison +V et la liaison O volt à la terre.

Si on considère le courant circulant dans les émetteurs-récepteurs du capteur double décrit plus haut, on voit que, par l'intermédiaire des liaisons d'alimentation, ce courant circule dans le fil de liaison 11 et passe à la terre à travers la résistance R de shunt soit $I_c$ l'intensité de ce courant. La tension $RI_c$ au point commun C des fils de liaison 10, 11 et 13 est alors appliquée aux deux comparateurs 9 et 12.

En cas d'incidents de coupure, $I_c$ diminue et un niveau bas de la tension $RI_c$ détecté par le comparateur 9 indique un état d'alarme correspondant à $RI_c$ inférieur à $U_2$ (niveau bas). Cet état d'alarme apparaît à la sortie du comparateur 9.

2°/ Court-circuit d'une ou des liaisons d'alimentation.

Lorsqu'il existe un court-circuit entre le +V d'alimentation et la masse, ou encore si un des composants du capteur est défectueux, l'intensité dans le circuit augmente. Ainsi, lorsque $I_c$ dépasse une certaine valeur, un niveau supérieur de cette intensité indique un état d'alarme correspondant à $RI_c$ supérieur à $U_3$ (niveau haut). Cet état d'alarme apparaît à la sortie du comparateur 12.

3°/ Coupure ou court-circuit à la masse d'une ou des liaisons d'au moins un capteur et/ou détection d'une absence de liquide.

Le circuit NAND référencé 6 qui est ainsi relié par les liaisons 4, 5 aux sorties des cellules réceptrices $3\underline{a}$ et $3\underline{b}$ détecte un ou des niveaux logiques O dans chaque cas où il y a coupure d'au moins une des liaisons d'un ou des capteurs et/ou une absence de liquide et/ou encore un court-circuit à la masse au O volt.

4°/ Court-circuit de la ou des liaisons d'au moins un des capteurs avec l'alimentation +V.

Les deux comparateurs 7 et 8 comparent les tensions à la sortie des cellules réceptrices $3\underline{a}$ et $3\underline{b}$ par rapport à la tension de référence $U_1$.

Les capteurs étant associés respectivement aux diviseurs de tension R2–R6 et R4–R5, la tension +V ne peut pas apparaître sur les fils de liaison 4 ou 5 sauf en cas de court-circuit de la ou des sorties d'au moins un des capteurs avec le +V de l'alimentation. La tension sur les fils de liaison 4 et 5 est alors comparée avec la tension $U_1$. Un règlage approprié de $U_1$ ($U_1$ inférieure ou égal à +V) provoque un état d'alarme à la sortie du comparateur 7 ou 8 correspondant lorsque la tension sur les fils 4 ou 5 atteint la valeur $U_1$.

Les divers états d'alarme mentionnés précédemment apparaissent en $\underline{S}$ à la sortie de la porte NAND 15.

Comme on le voit, l'ensemble du capteur double et de son circuit électronique associé constitue un détecteur de niveau à la sécurité positive.

Bien que cela n'ait pas été représenté, il est possible de réaliser le capteur avec des liaisons à fibres optiques, les divers émetteurs et récepteurs se trouvant à distance d'une zone supposée dangereuse. Un type de liaisons à fibres optique de ce type est représenté dans GB-A 1 518 492 dans une disposition cependant différente.

L'invention n'est pas limitée aux modes de réalisation représentés et décrits en détail car diverses modifications peuvent y être apportées sans sortir de son cadre.

## Revendications

1. Détecteur de niveau comprenant un prisme à réflexion totale (1) réalisé en une matière transparente et prévu pour détecter la présence ou l'absence d'un liquide, caractérisé par au moins deux capteurs émetteurs-récepteurs ($2\underline{a}$, $2\underline{b}$; $3\underline{a}$, $3\underline{b}$) montés par paire (A, B) sur la face dudit prisme où ne se produit pas ladite réflexion totale afin d'être reliés de manière électronique à au moins un dispositif logique (6) permettant de détecter la présence ou l'absence d'un signal lumineux reçu par au moins un des récepteurs (3a, 3b) de la partie de capteur.

2. Détecteur selon la revendication 1, caractérisé en ce que le prisme à réflexion totale (1) présente une forme cylindroconique d'angle au sommet inférieur égal à 90° et dont la partie plane supérieure reçoit la paire de capteur (2a, 2b; 3a, 3b), les émetteurs-récepteurs de chaque capteur étant montés à 180° l'un de l'autre et les capteurs de ladite paire étant situés à 90° l'un de l'autre.

3. Détecteur selon l'une des revendications 1 et 2, caractérisé en ce que les récepteurs (3a, 3b) de la paire de capteurs présentent en sortie le niveau logique 0 lorsqu'ils reçoivent und information émise par les émetteurs (2a, 2b) et un niveau logique 1 dans le cas contraire, le dispositif logique de détection comprenant alors une porte NAND (6) à fonction NON-ET.

4. Détecteur selon l'une des revendications 1 à 3, caractérisé en ce que les émetteurs (2a, 2b) et les récepteurs (3a, 3b) de la paire de capteurs sont des cellules de type infrarouge.

5. Détecteur selon l'une des revendications 1 à 4, caractérisé en ce que des comparateurs (7, 8) sont prévus à la sortie (4, 5) des récepteurs (3a, 3b), ces comparateurs étant reliés à une première tension de référence (U₁) pour détecteur un court-circuit d'une ou des liaisons d'au moins un des capteurs avec l'alimentation.

6. Détecteur selon l'une des revendications 1 à 5, caractérisé en ce que la sortie des émetteurs (2a, 2b) et l'entrée des récepteurs (3a, 3b) sont reliées en commun à la masse par l'intermédiaire d'une résistance de shunt (R), deux comparateurs (9, 12) reliés respectivement à une seconde et à une troisième tension de référence (U₂, U₃) étant prévus aux bornes de cette résistance pour détecter une coupure et respectivement un court-circuit des liaisons d'alimentation.

7. Détecteur selon l'une des revendications 1 à 6, caractérisé en ce que les sorties des comparateurs (7, 8, 9, 12) sont reliées entre elles à la première entrée d'un circuit logique NAND (15) dont la seconde entrée est reliée à la sortie de ladite porte NAND (6) afin de détecter les divers états d'alarme.

8. Détecteur selon l'une des revendications 1 à 7, caractérisé en ce qu'il comprend des liaisons à fibres optiques.

## Patentansprüche

1. Niveaudetektor, bestehend aus einem Totalreflexionsprisma (1) aus durchsichtigem Material, das die Anwesenheit oder Abwesenheit einer Flüssigkeit feststellt, gekennzeichnet durch wenigsten zwei Sender-Empfänger-Meßfühler (2a, 2b; 3a, 3b), die paarweise (A, B) einesteils optisch auf der Fläche des genannten Prismas, auf dem sich die genannte Totalreflexion nicht ereignet, miteinander verbunden und andererseits elektronisch durch wenigstens eine Logikeinheit (6) miteinander verbunden sind, welche es ermöglicht, die Anwesenheit oder Abwesenheit eines von wenigstens einem Empfänger (3a, 3b) der beiden Meßfühler empfangenen Lichtsignals festzustellen.

2. Detektor nach Anspruch 1, dadurch gekennzeichnet, daß das Totalreflexionsprisma (1) eine zylindrisch-konische Form aufweist, wobei der Winkel an der Spitze kleiner oder gleich 90° ist und wobei auf der oberen Fläche die beiden Meßfühler (2a, 2b; 3a, 3b) angeordnet sind und die Sender-Empfänger jedes Meßfühlers in einem 180° Winkel zueinander und die genannten beiden Meßfühler in einem 90° Winkel zueinander stehen.

3. Detektor nach einem der Ansprüche 1 oder 2, dadurch gekennzeichnet, daß die Empfänger (3a, 3b) der beiden Meßfühler am Ausgang das Logikniveau 0 zeigen, wenn sie eine von den zugehörigen Sendern (2a, 2b) abgestrahlte Information empfangen und das Logikniveau 1 im gegeteiligen Fall und daß die Feststell-Logikeinheit dementsprechend ein NAND-Gatter (6) mit der Funktion NICHT-UND enthält.

4. Detektor nach einem der Ansprüche 1 bis 3, dadurch gekennzeichnet, daß die Sender (2a, 2b) und die Empfänger (3a, 3b) der beiden Meßfühler Infrarot-Zellen sind.

5. Detektor nach einem der Ansprüche 1 bis 4, dadurch gekennzeichnet, daß am Ausgang (4, 5) der Empfänger (3a, 3b) Vergleicher (7, 8) vorgesehen sind, die an eine erste Referenzspannung (U₁) angeschlossen sind, um einen Kurzschluß in der/den Verbindung(en) wenigstens eines Meßfühlers oder beider Meßfühler mit der Stromversorgung festzustellen.

6. Detektor nach einem der Ansprüche 1 bis 5, dadurch gekennzeichnet, daß der Ausgang der Sender (2a, 2b) und der Eingang der Empfänger (3a, 3b) gemeinsam über einen Shunt-Widerstand (R) mit der Masse verbunden sind, daß zwei Vergleicher (9, 12), die jeweils mit einer zweiten und einer dritten Referenzspannung (U₂, U₃) verbunden sind, die am Ende dieses Widerstandes vorgesehen sind, um eine Unterbrechung und dementsprechend einen Kurzschluß der Versorgungsleitungen, festzustellen.

7. Detektor nach einem der Ansprüche 1 bis 6, dadurch gekennzeichnet, daß die Ausgänge der Vergleicher (7, 8, 9, 12) miteinander verbunden an den ersten Eingang eines logischen NAND-Schaltkreises (15) angelegt sind, dessen zweiter Eingang mit dem Ausgang des genannten NAND-Gatters (6) verbunden ist, um die verschiedenen Alarmzustände festzustellen.

8. Detektor nach einem der Ansprüche 1 bis 7, dadurch gekennzeichnet, daß er fiberoptische Verbindungsleitungen enthält.

## Claims

1. Level detector comprising a total reflection prism (1) made of transparent material and provided for detecting the presence or absence of a liquid, characterized by at least two emitting-receiving pick-ups (2a, 2b; 3a, 3b) mounted by pairs (A, B) on the face of said prism where said total reflection does not occur in order to be connected in an optical manner to said prism, and connected on the other hand in an electronic manner to at least one logic device (6) enabling to detect the presence or absence of a light signal received by at least one of the receivers (3a, 3b) of the pair of pick-ups.

2. Detector according to claim 1, characterized in that the total reflection prism (1) has a cylindro-conical shape with a lower apex angle equal to 90°, and the upper plane portion of which receives the pair of pick-ups (2a, 2b; 3a, 3b), the emitteres-receivers of each pick-up being mounted at 180° on with respect to the other, and the pick-ups of said pair being situated at 90° one with respect to the other.

3. Detector according to one of claims 1 and 2. characterized in that the receivers (3a, 3b) of the pair of pick-ups have, as output, the logic level 0 when they receive an information emitted by the emitters (2a, 2b) and a logic level 1 in the contrary case, the detection logic device then including a NAND gate (6) with a NOT-AND function.

4. Detector according to one of claims 1 to 3, characterized in that the emitters (2a, 2b) and the receivers (3a, 3b) of the pair of pick-ups are infrared type cells.

5. Detector according to one of claims 1 to 4, characterized in that comparators (7, 8) are provided at the output (4, 5) of the receivers (3a, 3b), these comparators being connected to a first reference voltage ($U_1$) for detecting a short-circuit of one or several of the connections of at least one of the pick-ups with the power supply.

6. Detector according to one of claims 1 to 5, characterized in that the output of the emitters (2a, 2b) and the input of the receivers (3a, 3b) are connected in common to the ground via a shunt resistor (R), two comparators (9, 12) respectively connected to a second and to a third voltage ($U_2$, $U_3$) being provided across this resistor for detecting a cutoff and respectively a short-circuit of the supply connections.

7. Detector according to one of claims 1 to 6, characterized in that the outputs of the comparators (7, 8, 9, 12) are connected together to the first input of a logic NAND circuit (15), the second input of which is connected to the output of said NAND gate (6) so as to detect the various states of alarm.

8. Detector according to one of claims 1 to 7, characterized in that it comprises optic fiber connections.

EP 0 245 563 B1

Fig.1

Fig.2

Fig.3

Fig.4